# EUROPÄISCHE PATENTSCHRIFT

(11) **EP 3 281 211 B1**
(45) Veröffentlichungstag und Bekanntmachung des Hinweises auf die Patenterteilung: **05.06.2019**
(21) Anmeldenummer: 16719833.2
(22) Anmeldetag: 25.04.2016
(51) Int. Cl.: H01B 12/16, H02G 15/34

(54) **VORRICHTUNG ZUR GLEICHSTROMÜBERTRAGUNG**
DEVICE FOR DC CURRENT TRANSMISSION
DISPOSITIF DE TRANSMISSION DE COURANT CONTINU

(30) Priorität: 22.05.2015 DE 102015209432
(43) Veröffentlichungstag der Anmeldung: 14.02.2018
(73) Patentinhaber: Siemens Aktiengesellschaft, 80333 München (DE)
(72) Erfinder: ARNDT, Tabea, 91056 Erlangen (DE); GRUNDMANN, Jörn, 91091 Grossenseebach (DE); IMAMOVIC, Denis, 90409 Nürnberg (DE); BAUER, Anne, 90768 Fürth (DE); NICK, Wolfgang, 90419 Nürnberg (DE); TENZER, Michael, 90425 Nürnberg (DE); VAN HASSELT, Peter, 91058 Erlangen (DE)
(86) Internationale Anmeldenummer: PCT/EP2016/059184
(87) Internationale Veröffentlichungsnummer: WO 2016/188688

(56) Entgegenhaltungen:
- EP-A1- 0 807 938
- EP-A1- 2 418 747
- JP-A- 2009 009 908
- US-A1- 2014 221 213

## Beschreibung

Die vorliegende Erfindung betrifft eine Vorrichtung zur Gleichstromübertragung mit einer supraleitenden Übertragungsleitung mit wenigstens einem supraleitendem Leiterelement und einer Kühlvorrichtung zur Kühlung eines radial innenliegenden Bereichs der Übertragungsleitung mit Hilfe eines fluiden Kühlmittels auf eine Temperatur unterhalb der Sprungtemperatur des supraleitenden Leiterelements. Es besteht ein Bedarf an Übertragungsleitungen für eine verlustarme Stromübertragung über lange Distanzen. Bei der Übertragung hoher elektrischer Leistungen über größere Distanzen sind Wechselstrom-Leitungen zunehmend ungeeignet, da die Eigeninduktivität der Übertragungsleitungen zu hohen Wechselstromverlusten führt. Für Distanzen oberhalb von einigen 10 km sind daher Gleichstromübertragungsleitungen besser geeignet, um höhere elektrische Leistungen verlustarm zu übertragen. Für eine solche Gleichstromübertragung wird meist ein zur Verfügung stehender Wechselstrom gleichgerichtet, als Gleichstrom übertragen und anschließend mittels Wechselrichterstationen erneut ins Wechselstrom-Netz eingespeist. Insbesondere durch die steigende Anschlussleistung regenerativ erzeugter Energie fernab von den Verbrauchern wächst der Bedarf für solche Vorrichtungen zur Übertragung hoher elektrischer Leistungen über längere Distanzen. Um diese hohen Leistungen übertragen zu können, werden zunehmend höhere Spannungen für die Gleichstromübertragung verwendet, beispielsweise Nennspannungen von 320 kV oder 525 kV. Ein Nachteil von herkömmlichen, normalleitenden Leitungen ist deren begrenzte Stromtragfähigkeit, was dazu führt, das in vielen Fällen mehrere Leitungen parallel verlegt werden müssen, um die erforderliche Leistung zu übertragen. Dies führt zu hohen Kosten und zum Teil auch zu einem hohen Platzbedarf. Bei einer Ausführung als Freileitung müssen hohe Abstände zwischen den einzelnen Leitungen eingehalten werden, um Spannungsüberschläge dazwischen zu vermeiden. Bei einer Übertragung über kabelgebundene Leiter müssen die Leiter innerhalb der Kabel über ausreichend spannungsfeste Dielektrika gegenüber der Umgebung isoliert werden. Solche isolierten Kabel werden typischerweise als unter Wasser verlegte Seekabel und/oder als unterirdisch verlegte Kabel eingesetzt. Bei der Verwendung von Kupfer als Leitermaterial sind für die Übertragung großer Ströme hohe Leiterquerschnitte nötig, so dass beispielsweise Seekabel für Leistungen von etwa 3 GW oft schon als getrennte Leitungen für eine bipolare Übertragung verlegt werden. Zur Einsparung von Kosten wäre es vorteilhaft, Leitungen auch für einen derart hohen Leistungsbereich als zweipolige Leitung mit zwei gemeinsam geführten Leitern ausgestalten zu können. Ein weiterer Nachteil von normalleitenden Übertragungsleitungen für die Hochspannungs-Gleichstromübertragung ist, dass die benötigten dicken dielektrischen Isolationsschichten gleichzeitig thermisch isolierend wirken. Durch diese Isolationswirkung kombiniert mit der Wärmeentwicklung durch elektrische Verluste heizen sich solche Übertragungsleitungen bei höheren Leistungen stark auf, was zu einer Beschädigung der Materialien, insbesondere der Isolationsschicht führen kann. Die durch eine Übertragungsleitung übertragene Leistung ist daher oft auch durch die Erwärmung des Leiters limitiert.

Um das Problem der geringen Stromtragfähigkeiten von derartigen Gleichstromleitungen zu lösen, wurden Gleichstromleitungen mit supraleitenden Leiterelementen vorgeschlagen, welche den Strom nahezu verlustfrei und mit sehr hohen Stromdichten transportieren können. Eine Vorrichtung mit supraleitenden Leiterelementen ist der Druckschrift EP 0 807 938 A1 zu entnehmen. Die supraleitenden Leiterelemente in solchen Leitungen müssen allerdings durch eine zusätzliche Kühlvorrichtung auf eine Betriebstemperatur unterhalb der Sprungtemperatur des Supraleiters gekühlt werden. Diese Betriebstemperatur kann abhängig von der Wahl des supraleitenden Materials beispielsweise zwischen 4 K und 100 K liegen. Bei bekannten supraleitenden Übertragungsleitungen wird diese Kühlung durch die Zirkulation eines fluiden Kühlmittels in einem geschlossenen Kreislauf durch das Innere der Leitung erreicht. Hierbei werden für größere Leitungslängen oberhalb von 10 km Zwischenkühlstationen verwendet, um das auf einem Teilstück der Leitung erwärmte Kühlmittel wieder herunter zu kühlen und erneut in das Leitungsinnere einzuspeisen. Das entlang der Leitungslänge strömende Kühlmittel wird dabei sowohl durch die thermische Kopplung mit der Umgebung als auch durch mechanische Reibung und verbleibende elektrische Verluste so weit erwärmt, dass ab einer bestimmten Leitungslänge ohne solche zwischengelagerte Kühlstationen die erforderliche Betriebstemperatur des Supraleiters nicht mehr gewährleistet werden kann. Der Einsatz solcher Zwischenkühlstationen führt zu einem vergleichsweise großen apparativen Aufwand. Bei einer Verlegung der Übertragungsleitungen über Land oder im Erdreich ist der Einbau solcher Zwischenkühlstationen möglicherweise noch zu vertreten, aber der Einsatz längerer supraleitender Übertragungsleitungen als Seekabel würde durch die Notwendigkeit solcher Zwischenkühlstationen im unter Wasser liegenden Bereich sowohl technisch als auch wirtschaftlich vollkommen uninteressant.

Aufgabe der Erfindung ist es daher, eine Vorrichtung zur Gleichstromübertragung anzugeben, welche die genannten Nachteile überwindet. Insbesondere soll eine solche Vorrichtung zur Verfügung gestellt werden, welche eine Übertragung hoher elektrischer Leistung über längere Entfernungen mit geringem apparativem Aufwand ermöglicht.

Diese Aufgabe wird durch die in Anspruch 1 beschriebene Vorrichtung gelöst. Die erfindungsgemäße Vorrichtung zur Gleichstromübertragung weist eine supraleitende Übertragungsleitung mit wenigstens einem supraleitenden Leiterelement und einer Kühlvorrichtung zur Kühlung eines radial innenliegenden Bereichs der Übertragungsleitung mit Hilfe eines fluiden Kühlmittels auf eine Temperatur unterhalb der Sprungtemperatur des supraleitenden Leiterelements auf. Die supraleitende Übertragungsleitung weist eine vakuumisolierte Hülle zur thermischen Trennung des innenliegenden Bereichs der Leitung von einer wärmeren äußeren Umgebung auf. Weiterhin umfasst die Kühlvorrichtung wenigstens eine Einspeisevorrichtung zur Einspeisung von Kühlmittel an einem Endbereich der Leitung in den innenliegenden Bereich der Übertragungsleitung. Die Leitung weist eine Längsausdehnung von wenigstens 20 km auf und ist auf dieser Länge frei von axial innenliegend angeordneten Einspeisevorrichtungen zur Einspeisung von Kühlmittel.

Mit anderen Worten weist die Übertragungsleitung nur höchstens an seinen beiden Enden solche Einspeisevorrichtungen auf. In den axial innenliegenden Bereichen, also im ganzen mittleren Bereich in Längsrichtung zwischen den beiden Endbereichen der Leitung, sind keine Einspeisevorrichtungen zur Einspeisung von Kühlmittel in ein Inneres der Leitung angeordnet. Es kann also beispielsweise entweder nur eine einzige Einspeisevorrichtung an nur einem Ende der Leitung vorliegen, oder es liegen insgesamt Einspeisevorrichtungen an beiden Enden der Leitung vor.

Der Kerngedanke der vorliegenden Erfindung besteht darin, dass das supraleitende Leiterelement durch die vakuumisolierte Hülle thermisch hinreichend von der äußeren Umgebung getrennt und die elektrischen Verluste und mechanischen Reibungsverluste ausreichend gering gehalten werden, um Zwischenkühlstationen auf innenliegenden Abschnitten der Leitung zu vermeiden. Aufgrund der thermischen Trennung und der geringen Verluste wird das supraleitende Leiterelement durch die Kühlwirkung des fluiden Kühlmittels auf der ganzen Länge der Leitung auf einer Betriebstemperatur unterhalb der Sprungtemperatur des Supraleiters gehalten. Vorteilhaft kann eine solche supraleitende Übertragungsleitung dann als Seekabel unter Wasser eingesetzt werden. Alternativ oder zusätzlich kann die Leitung prinzipiell auch als unterirdisch verlegtes Kabel und/oder als Überland-Kabel verlegt werden. Der Einsatz als Seekabel über Längen von mehr als 10 km wird durch die erfindungsgemäße Ausgestaltung überhaupt erst ermöglicht. Ein Vorteil gegenüber Vorrichtungen zur Gleichstromübertragung mit normalleitenden Übertragungsleitungen ist, dass mit einer solchen erfindungsgemäßen Vorrichtung eine sehr hohe Stromtragfähigkeit erreicht werden kann. Hierdurch wird die Übertragung hoher Leistungen schon in mittleren Spannungsbereichen ermöglicht. Weiterhin können hohe Leistungen vorteilhaft über eine zweipolige Leitung übertragen werden, in der zwei supraleitende Leiter gemeinsam innerhalb einer Vakuumisolation geführt werden.

Ein Verfahren zur Kühlung eines supraleitenden Leiterelements in einer solchen Vorrichtung auf eine Temperatur unterhalb seiner Sprungtemperatur ist dadurch charakterisiert, dass das fluide Kühlmittel nur an einem oder zwei Endbereichen der Leitung in den innenliegenden Bereich der Leitung eingespeist wird. Die Vorteile des Verfahrens ergeben sich analog zu den Vorteilen der erfindungsgemäßen Vorrichtung.

Vorteilhafte Ausgestaltungen und Weiterbildungen der Erfindung gehen aus den von Anspruch 1 abhängigen Ansprüchen sowie der folgenden Beschreibung hervor. Vorteilhaft kann die Übertragungsleitung eine Längsausdehnung von wenigstens 50 km, insbesondere wenigstens 100 km, aufweisen und auf dieser Länge frei von axial innenliegend angeordneten Einspeisevorrichtungen sein.

Die Übertragungsleitung kann einen das supraleitende Leiterelement ringförmig umgebenden Kühlmittelkanal zum Transport von fluidem Kühlmittel entlang der Längsrichtung der Leitung aufweisen. So kann das Kühlmittel auf einfache Weise von einem ersten Leitungsende, das eine Einspeisevorrichtung aufweist, zu einem zweiten Leitungsende transportiert werden und dabei auf der Länge der Übertragungsleitung dessen innenliegenden Bereich wirksam kühlen. Durch die den Leiter außen ringförmig umgebende Anordnung kann der Kühlmittelkanal dabei gleichzeitig zur thermischen und/oder elektrischen Isolation von der äußeren Umgebung dienen. Mit anderen Worten wirkt das im Kühlmittelkanal transportierte fluide Kühlmittel gleichzeitig als dielektrische Isolationsschicht der Übertragungsleitung.

Die Übertragungsleitung kann einen das supraleitende Leiterelement ringförmig umgebenden elektrisch leitenden Leitungsschirm aufweisen und zwischen supraleitendem Leiterelement und Leitungsschirm eine ringförmige dielektrische Isolationsschicht aufweisen, wobei die dielektrische Isolationsschicht fluides Kühlmittel umfasst. Allgemein sollen unter den genannten "ringförmigen" Strukturen solche Strukturen verstanden werden, die im Querschnitt der Leitung die weiter innen liegenden Bereiche ringförmig umgeben und die sich entlang der Längsrichtung der Leitung als lange, hohlzylindrische Strukturen erstrecken. Sie können sich insbesondere über die gesamte Länge der Leitung erstrecken. Der ringförmige Leitungsschirm kann grundsätzlich normalleitend und/oder supraleitend ausgestaltet sein. Beispielsweise kann der Leitungsschirm einen metallischen Leiter, insbesondere Kupfer oder Aluminium, aufweisen. Der Leitungsschirm kann beispielsweise als durchgehende, homogene zylindrische Schicht ausgebildet sein, oder er kann als Band oder Geflecht von elektrischen Leitern auf die weiter innenliegenden Elemente der Leitung gewickelt sein. Insbesondere kann es sich bei dem genannten Leitungsschirm, der von dem Leiterelement zumindest durch den genannten Kühlmittelkanal getrennt ist, um den vom Leiterelement aus gesehen ersten, also am weitesten innenliegenden, Leitungsschirm handeln.

Die radial zwischen Leiterelement und Leitungsschirm angeordnete dielektrische Isolationsschicht ist in dieser Ausführungsform zumindest teilweise durch fluides Kühlmittel gebildet. Dies kann insbesondere das in einem ringförmigen Kühlmittelkanal in Längsrichtung der Leitung strömende Kühlmittel sein, welches von einem Ende der Leitung aus eingespeist wird. Ein Vorteil dieser Ausführungsform ist, dass im Fall eines Spannungsdurchschlags der durch das fluide Kühlmittel gebildete Teil der Isolationsschicht im Gegensatz zu einem Festkörperdielektrikum nicht dauerhaft zerstört wird, da dieser Teil durch nachströmendes Kühlmittel ersetzt werden kann. Eine solche Ausführung mit Kühlmittel als Teil der Isolationsschicht eignet sich besonders für die Gleichstromübertragung im Mittelspannungsbereich, also beispielsweise mit Spannungen zwischen 10 kV und 123 kV, da in diesem Spannungsbereich beispielsweise flüssiger Stickstoff und flüssiger Wasserstoff genügend durchschlagsfest sind. Besonders bevorzugt ist der Einsatz für die Gleichstromübertragung im Spannungsbereich zwischen 10 kV und 36 kV.

Die genannten Ausführungsformen, bei denen das Kühlmittel zumindest einen Teil der dielektrischen Isolationsschicht zwischen Leiterelement und Leitungsschirm darstellt, können allgemein auch dann vorteilhaft sein, wenn die Übertragungsleitung eine Länge unterhalb von 20 km aufweist. Auch bei solchen kürzeren Leitungen kann die beschriebene doppelte Wirkung des Kühlmittels im ringförmigen Kühlmittelkanal vorteilhaft zur Erzielung einer effizienten Kühlung bei gleichzeitig hoher Durchschlagfestigkeit der Übertragungsleitung sein.

Die dielektrische Isolationsschicht kann vorteilhaft eine Durchschlagfestigkeit von wenigstens 20 kV/mm aufweisen. Sie kann also so durchschlagsfest ausgestaltet sein, dass mit der Vorrichtung eine Gleichstromübertragung bei Spannungen oberhalb von 1 kV und/oder Übertragungsleistungen oberhalb von 500 MW ermöglicht wird, ohne dass es zu Spannungsüberschlägen zwischen Leiterelement und Leitungsschirm kommt. Besonders vorteilhaft kann die Übertragungsleistung mit einem supraleitenden Leiterelement allgemein sogar oberhalb von 3 GW liegen. Der pro Leiterelement übertragene Strom kann vorteilhaft bei wenigstens 5 kA, insbesondere wenigstens 10 kA, liegen, unabhängig davon, ob es sich um eine einpolige oder mehrpolige Übertragungsleitung handelt.

Die dielektrische Isolationsschicht kann insbesondere mehrheitlich aus fluidem Kühlmittel gebildet sein. Mit anderen Worten kann ein überwiegender Anteil des Volumens der Isolationsschicht durch fluides Kühlmittel gegeben sein. Die dielektrische Isolationsschicht ist im Wesentlichen durch den mit Kühlmittel gefüllten ringförmigen Kühlmittelkanal gebildet, wobei der hohlzylindrische Kanal neben dem Kühlmittel zusätzliche elektrisch isolierende Stützelemente zur Abstützung der weiter innen liegenden Elemente der Leitung aufweisen kann. Wesentlich ist, dass die Übertragungsleitung radial durchgehende axiale Segmente und/oder azimutale Segmente aufweist, in denen die dielektrische Isolationsschicht vollständig durch fluides Kühlmittel gebildet ist. Die zwischen diesen Segmenten optional vorhandenen Stützelemente können stegartig ausgebildet sein. Sie können beispielsweise aus Edelstahl, glasfaserverstärktem Kunststoff und/oder Gießharz gebildet sein.

Die dielektrische Isolationsschicht kann auch wenigstens eine Schicht eines in Kühlmittel eingebetteten Papiers aufweisen. Insbesondere kann das Papier dabei von fluidem Kühlmittel umströmt werden. Das Papier kann vorteilhaft als Polypropylenlaminiertes Papier (abgekürzt PPLP) vorliegen, welches besonders durchschlagsfest ist. Eine solche PPLP-Schicht besteht aus einem Laminat eines Polypropylen-Films, welcher beidseitig von Zellulose-Papier benachbart ist. Vorteilhaft kann die dielektrische Isolationsschicht auch einen Stapel aus mehreren derartigen Papieren aufweisen, wobei die einzelnen Papierlagen jeweils von fluidem Kühlmittel umströmt werden. Dabei kann das Papier entweder in einem Haupt-Kühlmittelkanal der Leitung angeordnet sein, oder das Kühlmittel kann parallel zu seinem Fluss in einem Haupt-Kühlmittelkanal das Papier zusätzlich in einem parallelen zweiten Kühlmittelkanal umströmen. Für einen ringförmigen Kühlmittelkanal, bei dem von Kühlmittel umströmtes Papier zur dielektrischen Isolation verwendet wird, können zusätzliche stegartige Stützstrukturen für die weiter innen liegenden Elemente vorteilhaft entfallen, und die Leitung kann insgesamt mechanisch robuster ausgestaltet werden als bei einer Aufhängung der innen liegenden Elemente mittels separater Stützstrukturen.

Wird die dielektrische Isolationsschicht durch eine Kombination von PPLP und fluidem Kühlmittel gebildet, dann können vorteilhaft besonders hohe Durchschlagfestigkeiten erzielt werden, und die Vorrichtung zur Gleichstromübertragung kann beispielsweise bei Nennspannungen oberhalb von 100 kV, insbesondere oberhalb von 320 kV betrieben werden. Solche Nennspannungen können mit einer dielektrischen Isolationsschicht, die zumindest in Teilsegmenten nur durch fluides Kühlmittel gebildet wird, nur schwer erreicht werden, da beispielsweise die Durchschlagspannung von flüssigem Stickstoff oder flüssigem Wasserstoff nicht linear mit der Schlagweite ansteigt: Bei einer Verdoppelung der Schlagweite steigt die Spannungsfestigkeit nur näherungsweise um einen Faktor 1,6. Die Schlagweite müsste daher bei einer Isolation nur über das fluide Kühlmittel bei steigender Nennspannung überproportional ansteigen, was gleichzeitig die Inhomogenität des elektrischen Feldes erhöht und wiederum zu lokalen Feldstärkeerhöhungen und damit zu noch größeren Schlagweiten führt. Daher ist eine Isolationsschicht mit einer Kombination aus einem Papierlaminat und fluidem Kühlmittel für die höheren Spannungsbereiche besonders vorteilhaft.

Das fluide Kühlmittel kann im Inneren der Übertragungsleitung zumindest auf einem mehrheitlichen Teil der Längsausdehnung der Leitung im Inneren eines glattwandigen Rohr geführt sein. Unter einem glattwandigen Rohr soll dabei ein solches Rohr verstanden werden, welches neben der natürlichen herstellungsbedingten Rauhigkeit seiner Oberfläche keine regelmäßige, übergeordnete Struktur aufweist. Insbesondere soll das Rohr zumindest in dem genannten mehrheitlichen Teil nicht als Wellrohr ausgebildet sein. Die Amplitude einer Oberflächenstruktur senkrecht zur lokalen Oberfläche des Rohrs soll in jedem Fall nicht größer sein als die Wandstärke der außenliegenden Begrenzungswand des Rohrs. Durch diese Ausgestaltung wird erreicht, dass der Strömungswiderstand für das zu transportierende Kühlmittel gering gehalten wird und Verwirbelungen des Kühlmittels minimiert werden. Hierdurch kann zum einen ein ausreichend hoher Massendurchsatz des Kühlmittels erreicht werden, um die über die Leitungslänge benötigte Kühlleistung auch in einem niedrigen Druckbereich zu gewährleisten. Zum anderen kann eine Erwärmung durch mit einer Verwirbelung einhergehende mechanische Reibungsverluste gering gehalten werden. Weiterhin ist die thermisch wirksame Oberfläche bei mit glatten Rohren vakuumisolierten Leitungen im Vergleich zu Leitungen mit gewellter Außenhülle verringert, was wiederum die Anforderungen an die Kühlleistung verringert. Diese Merkmale können vorteilhaft dazu beitragen, eine Kühlung des Leiters über besonders lange Leitungslängen zu ermöglichen, ohne dass zusätzliche axial innenliegende Zwischenkühlstationen benötigt werden. Besonders vorteilhaft wird der Kühlmittelkanal auf der ganzen Länge der Übertragungsleitung durch ein glattwandiges Rohr begrenzt.

Glattwandige Kühlmittelrohre haben grundsätzlich den Nachteil einer geringeren mechanischen Flexibilität bei einer Verlegung der Übertragungsleitung. Dieser Nachteil kann dadurch ausgeglichen werden, dass zwischen einzelnen Segmenten mit glattwandigen Begrenzungsrohren vergleichsweise kürzere Segmente mit gewellten Begrenzungsrohren angeordnet werden. So kann trotzdem eine höhere Beweglichkeit der Leitung durch Biegung an vorbestimmten Stellen ermöglicht werden. Auch für eine beispielsweise durch thermische Ausdehnung oder Schrumpfung bedingte Längenkompensation der Leitung kann die Anordnung solcher Segmente mit gewellten Kühlmittelrohren vorteilhaft sein. Die Verwirbelung in diesen gewellten Segmenten kann trotzdem dadurch gering gehalten werden, dass ein gewellt ausgestaltetes äußeres Kühlmittelrohr mit einem eingesteckten glatten Rohrstück ausgekleidet wird, so dass im Inneren dieses glatten Rohrstücks fließende Kühlmittel wiederum nur eine geringe Verwirbelung erfährt.

Das supraleitende Leiterelement kann vorteilhaft ein hochtemperatursupraleitendes Material umfassen. Hochtemperatursupraleiter (HTS) sind supraleitende Materialien mit einer Sprungtemperatur oberhalb von 25 K und bei einigen Materialklassen, beispielsweise den Cuprat-Supraleitern, oberhalb von 77 K, bei denen die Betriebstemperatur durch Kühlung mit anderen kryogenen Materialien als flüssigem Helium erreicht werden kann. HTS-Materialien sind auch deshalb besonders attraktiv, da diese Materialien abhängig von der Wahl der Betriebstemperatur sehr hohe kritische Stromdichten aufweisen können.

Insbesondere kann das hochtemperatursupraleitende Material Magnesiumdiborid umfassen. Besonders vorteilhaft kann das Leiterelement als Hauptbestandteil Magnesiumdiborid aufweisen oder sogar im Wesentlichen aus Magnesiumdiborid bestehen. Magnesiumdiborid weist eine Sprungtemperatur von etwa 39 K auf und gilt somit als Hochtemperatur-Supraleiter, allerdings ist die Sprungtemperatur im Vergleich zu anderen HTS-Materialien eher niedrig. Die Vorteile dieses Materials im Vergleich zu oxidkeramischen Hochtemperatur-Supraleitern liegen bei seiner leichten und somit kostengünstigen Herstellbarkeit. Auf Magnesiumdiborid basierende Leiter können besonders einfach und günstig durch Aerosoldeposition oder durch das sogenannte Powder-in-Tube-Verfahren hergestellt werden.

Alternativ oder zusätzlich kann das Leiterelement aber auch andere hochtemperatursupraleitende Materialien umfassen, beispielsweise HTS-Materialien der zweiten Generation, also Verbindungen des Typs REBa₂Cu₃Oₓ (kurz REBCO), wobei RE für ein Element der seltenen Erden oder eine Mischung solcher Elemente steht. REBCO-Supraleiter können aufgrund ihrer hohen Sprungtemperaturen auch mit flüssigem Stickstoff gekühlt werden und weisen vor allem bei tieferen Temperaturen als 77 K eine besonders hohe Stromtragfähigkeit auf.

Andere vorteilhafte Materialien sind HTS-Materialien der ersten Generation, beispielsweise die verschiedenen Varianten des Bismut-Strontium-Calcium-Kupferoxids. Alternativ können auch supraleitende Pnictide zum Einsatz kommen. Aufgrund ihrer eher niedrigen Sprungtemperatur kommen supraleitende Pnictide für eine Betriebstemperatur von etwa 20 bis 30 K in Frage.

Besonders vorteilhaft kann die Kühlvorrichtung nur an einem der Endbereiche der Leitung eine Vorrichtung zur Einspeisung von Kühlmittel aufweisen. Mit anderen Worten kann die Übertragungsleitung so ausgestaltet sein, dass das von einem Ende eingespeiste Kühlmittel zur Kühlung des Leiters auf seine Betriebstemperatur auf der ganzen Länge der Leitung ausreicht. Die Leitung kann dann entweder nur einen Kühlmittelkanal aufweisen, in dem das Kühlmittel nur in einer Richtung, nämlich vom Einspeise-Ende zum anderen Ende der Leitung transportiert wird. Alternativ kann die Leitung aber auch zwei Kühlmittelkanäle aufweisen, über die das Kühlmittel in Form eines geschlossenen Kreislaufs wieder zum Leitungsende mit der Einspeisevorrichtung zurücktransportiert wird. Am gegenüberliegenden Ende sind dann die beiden Kühlmittelkanäle zweckmäßig miteinander verbunden.

Allgemein kann die Übertragungsleitung zwei fluidisch getrennte Kühlmittelkanäle zum Transport des fluiden Kühlmittels in entgegengesetzter Richtung aufweisen. Dies kann sowohl bei der vorgenannten Ausführungsform mit nur einer Einspeisevorrichtung als auch bei Ausführungsformen mit einer separaten Einspeisevorrichtung an jedem Leitungsende zweckmäßig sein. In beiden Fällen kann über die beiden in einer Übertragungsleitung geführten Kühlmittelkanäle ein geschlossener Kühlmittelkreislauf zur Verfügung gestellt werden, über das Kühlmittel mit gleichem Stofftransport in Hin- und Rückrichtung zirkulieren kann. Alternativ kann ein solcher geschlossener Kreislauf aber auch über die Kopplung zweier parallel verlegter Leitungen erreicht werden, die beispielsweise jeweils nur einen Kühlmittelkanal aufweisen und von denen das eine für den Hintransport und das andere für den Rücktransport des Kühlmittels verwendet wird.

Bei einer Ausführungsform mit zwei fluidisch getrennten Kühlmittelkanälen in einer Übertragungsleitung können diese entweder ineinander geschachtelt sein oder nebeneinander verlaufen. Bei einer geschachtelten Ausführung können sie vorteilhaft koaxial angeordnet sein. Alternativ können auch zwei innere azentrische Kühlmittelkanäle innerhalb eines äußeren Kühlmittelkanals angeordnet sein.

Die Übertragungsleitung kann als zweipolige Leitung mit zwei elektrisch voneinander isolierten supraleitenden Leiterelementen innerhalb einer gemeinsamen vakuumisolierten Hülle ausgestaltet sein. Hiermit kann Gleichstrom besonders vorteilhaft über nur eine einzige zweipolige Leitung übertragen werden, was gegenüber der Verwendung zweier einpoliger Leitungen zu Einsparnissen bei den Materialien und bei der Verlegung der Leitung führt. Die Einbettung beider Leiterelemente in eine gemeinsame Leitung wird durch die hohe Durchschlagfestigkeit der beschriebenen dielektrischen Isolationsschichten, insbesondere unter Verwendung des Kühlmittels als Isolator, ermöglicht. Die Anordnung der beiden Leiterpole in einer gemeinsam vakuumisolierten Leitung verringert auch die insgesamt auftretenden thermischen Verluste und somit den Aufwand für die Kühlung, da die für die thermischen Verluste wirksame Gesamt-Oberfläche der Leitung im Vergleich zu einer Ausführung mit zwei getrennt vakuumisolierten Leitungen kleiner ist. Besonders bei Nennspannungen bis zu etwa 123 kV ist die Anordnung zweier Pole in einer gemeinsam vakuumisolierten Leitungshülle besonders vorteilhaft, da in diesem Bereich eine elektrische Isolation über das Kühlmittel besonders einfach erreicht werden kann.

Die beiden Leiterelemente einer solchen zweipoligen Leitung können prinzipiell entweder nebeneinander oder koaxial ineinander verschachtelt geführt werden.

Die Übertragungsleitung kann allgemein zwei koaxial zueinander verlaufende Kühlmittelkanäle aufweisen. Diese können, wie vorab beschrieben, zum Transport von Kühlmittel in entgegengesetzten Richtungen ausgestaltet sein. Prinzipiell kann das Kühlmittel aber auch in beiden Kanälen in dieselbe Richtung transportiert werden. Dann kann der Rücktransport beispielsweise in einer anderen Übertragungsleitung erfolgen, oder es kann auch ein Netto-Stofftransport des Kühlmittels in die gegebene Transportrichtung erfolgen. Die beiden konzentrisch verlaufenden Kühlmittelkanäle können beispielsweise auch mit unterschiedlichem fluidem Kühlmittel befüllt sein.

Ein grundsätzlicher Vorteil der Ausführungsformen mit zwei ineinander geschachtelten Kühlmittelkanälen ist, dass ein erster innerer Kühlmittelkanal mit einem geringeren Massendurchsatz betrieben werden kann als bei herkömmlichen Leitungen, da das Kühlmittel im äußeren, zweiten Kühlmittelkanal die von außen auftretende Wärmelast, insbesondere die Wärmestrahlung, zum großen Teil aufnehmen kann. Auf diese Weise wird über die Länge der Leitung nur ein geringer Anstieg der Temperatur des Kühlmittels im inneren Kühlmittelkanal verursacht, und das supraleitende Leiterelement kann auf der ganzen Leitungslänge auf einer Temperatur unterhalb seiner Sprungtemperatur gehalten werden. Für den äußeren Kühlmittelkanal kann dabei eine deutlich höhere Temperatur zugelassen werden als für den inneren Kühlmittelkanal. Bei einer Einspeisung von frischem, herunter gekühltem Kühlmittel an nur einem Ende der Übertragungsleitung eignet sich diese Ausführungsform daher besonders gut, um das auf der Länge der Leitung erwärmte Kühlmittel aus dem inneren Kanal im äußeren Kühlmittelkanal zur Kühlvorrichtung und Einspeisevorrichtung zurück zu transportieren. Vorteilhaft können innerer und äußerer Kühlmittelkanal durch eine zusätzliche vakuumisolierte Hülle thermisch voneinander getrennt sein.

Das fluide Kühlmittel kann vorteilhaft Stickstoff, Wasserstoff, Helium und/oder Neon aufweisen. Insbesondere kann das Kühlmittel vollständig aus einem dieser Stoffe bestehen. Allgemein kann das Kühlmittel dabei im flüssigen, gasförmigen und/oder überkritischen Zustand vorliegen. Dabei kann die Wahl des Kühlmittels zweckmäßig an die gewünschte Betriebstemperatur des gewählten Supraleiters angepasst werden. Beispielsweise können HTS-Materialien zweiter Generation gut mit flüssigem Stickstoff gekühlt werden, während Magnesiumdiborid besonders vorteilhaft mit flüssigem oder überkritischem Wasserstoff gekühlt werden kann. Die Verwendung eines überkritischen Kühlmittels, insbesondere überkritischen Wasserstoffs, ist besonders vorteilhaft, da in diesem Zustand die Blasenbildung durch ein Sieden des Kühlmittels im Kühlmittelkanal ausgeschlossen wird und somit die Spannungsfestigkeit bei einer Nutzung des Kühlmittels als dielektrisches Isolationsmittel erhöht wird. Die Betriebstemperatur des supraleitenden Leiterelements kann beispielsweise bei einer Kühlung mit Wasserstoff zwischen 20 und 35 K oder bei einer Kühlung mit Stickstoff zwischen 65 und 80 K liegen.

Zusätzlich zu der vakuumisolierten Hülle kann der innenliegende Bereich der Übertragungsleitung durch eine mehrlagige Superisolation thermisch von der äußeren Umgebung abgeschirmt sein. Diese Superisolation kann beispielsweise innerhalb der vakuumisolierten Hülle angeordnet sein. Alternativ oder zusätzlich kann eine solche Superisolation jedoch auch an anderen radialen Positionen vorliegen.

Der Leitungsschirm kann als separate elektrisch leitfähige Schicht innerhalb der vakuumisolierten Hülle angeordnet sein, oder er kann als Teil der vakuumisolierten Hülle ausgestaltet sein. Hierzu kann beispielsweise eine elektrisch leitende Innenwand des vakuumisolierten Kryostaten als Leitungsschirm verwendet werden.

Der Kühlmittelkanal kann vorteilhaft zwischen elektrischem Leiter und Leitungsschirm angeordnet sein, um das im Kühlmittelkanal fließende Kühlmittel gleichzeitig als dielektrische Isolationsschicht zu nutzen. Alternativ oder zusätzlich kann jedoch auch ein Kühlmittelkanal zwischen Leitungsschirm und vakuumisolierter Hülle angeordnet sein. Ein solcher zusätzlicher äußerer Kühlmittelkanal kann, wie vorab beschrieben, zur zusätzlichen thermischen Abschirmung eines inneren Kühlmittelkanals von der warmen äußeren Umgebung dienen.

Der Druck in dem Kühlmittelkanal oder den Kühlmittelkanälen der Leitung kann allgemein vorteilhaft bei höchstens 20 bar, besonders vorteilhaft bei höchstens 5 bar liegen. Die beschriebene Ausführung mit einem Kühlmitteltransport in mehrheitlich glatten Rohren ermöglicht eine ausreichende Kühlung der innenliegenden Bereiche der Leitung mit einer Kühlmitteleinspeisung in diesem Druckbereich.

Bei dem Verfahren zu Kühlung des supraleitenden Leiterelements kann die Übertragungsleitung vorteilhaft zum Stofftransport des Kühlmittels entlang der Längsrichtung der Leitung genutzt werden. Hierzu kann eine entlang einer ersten Richtung der Übertragungsleitung transportierte Menge des Kühlmittels größer sein als eine in einer entgegengesetzten zweiten Richtung der Leitung transportierte Menge. Diese Ausführungsform des Verfahrens kann insbesondere dann nützlich sein, wenn die supraleitende Übertragungsleitung zusätzlich zur Gleichstromübertragung auch zum Transport von durch Elektrolyse gewonnenem Wasserstoff genutzt werden soll. Hierdurch kann die durch die Leitung insgesamt übertragene Leistung in Form von elektrischer und chemischer Energie im Vergleich zur reinen Stromübertragung deutlich erhöht werden.

Nachfolgend wird die Erfindung anhand einiger bevorzugter Ausführungsbeispiele unter Bezugnahme auf die angehängten Zeichnungen beschrieben, in denen:
- Figur 1: eine Übertragungsleitung nach einem ersten Ausführungsbeispiel im schematischen Querschnitt zeigt,
- Figur 2: eine Übertragungsleitung nach einem zweiten Ausführungsbeispiel im schematischen Längsschnitt zeigt,
- Figur 3: eine Prinzipskizze einer Vorrichtung zur Stromübertragung nach einem dritten Ausführungsbeispiel zeigt,
- Figur 4: eine Übertragungsleitung nach einem vierten Ausführungsbeispiel im schematischen Querschnitt zeigt,
- Figur 5: eine Übertragungsleitung nach einem fünften Ausführungsbeispiel im schematischen Querschnitt zeigt,
- Figur 6: eine Prinzipskizze einer Vorrichtung zur Stromübertragung nach einem sechsten Ausführungsbeispiel zeigt,
- Figur 7: eine Prinzipskizze einer Vorrichtung zur Stromübertragung nach einem siebten Ausführungsbeispiel zeigt,
- Figur 8: eine Übertragungsleitung nach einem achten Ausführungsbeispiel im schematischen Querschnitt zeigt,
- Figur 9: eine Übertragungsleitung nach einem neunten Ausführungsbeispiel im schematischen Querschnitt zeigt,
- Figur 10: eine Übertragungsleitung nach einem zehnten Ausführungsbeispiel im schematischen Querschnitt zeigt,
- Figur 11: eine Prinzipskizze einer Vorrichtung zur Stromübertragung nach einem elften Ausführungsbeispiel zeigt und
- Figur 12: eine Übertragungsleitung nach einem zwölften Ausführungsbeispiel im schematischen Querschnitt zeigt.

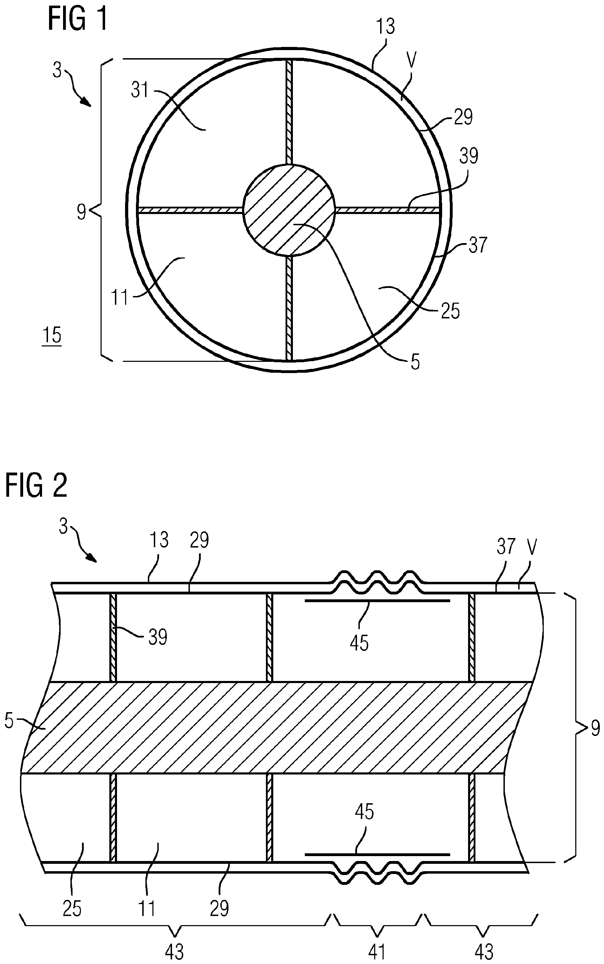

In Figur 1 ist ein schematischer Querschnitt einer Übertragungsleitung 3 aus einer Vorrichtung zur Gleichstromübertragung nach einem ersten Ausführungsbeispiel der Erfindung gezeigt. Gezeigt ist ein im Zentrum der Leitung 3 angeordnetes supraleitendes Leiterelement 5, welches beispielsweise einen supraleitenden Draht oder ein normalleitendes oder nichtleitendes Substrat mit einer hochtemperatursupraleitenden Schicht aufweisen kann. Das supraleitende Leiterelement 5 kann dabei aus verschiedenen Materialien aufgebaut sein und verschiedene Leiterformen aufweisen. Es kann beispielsweise auch aus mehreren Filamenten einzelner supraleitender Leiter zusammengesetzt sein. Das supraleitende Material des supraleitenden Leiterelements 5 wird durch ein fluides Kühlmittel 11 gekühlt, welches in einem das Leiterelement 5 ringförmig umgebenden Kühlmittelkanal 25 strömt. Bei dem fluiden Kühlmittel 11 kann es sich beispielsweise um flüssigen Stickstoff oder um flüssigen oder überkritischen Wasserstoff handeln, welcher in einer außerhalb des der Leitung 3 angeordneten Kühleinheit auf eine kryogene Temperatur heruntergekühlt wird und von einem Ende der Leitung 3 in einen radial innenliegenden Bereich 9 eingespeist wird. Durch das fluide Kühlmittel 11 wird das supraleitende Leiterelement 5 auf eine Betriebstemperatur unterhalb der Sprungtemperatur des Supraleiters gekühlt.

Das supraleitende Leiterelement 5 wird durch Stützelemente 39 im Zentrum der Leitung 3 gehalten, wodurch rings um das Leiterelement 5 ein Mindestabstand zu der Außenhülle der Leitung gewährleistet wird. Der Kühlmittelkanal 25 ist radial außerhalb von einer vakuumisolierten doppelwandigen Hülle 13 umgeben, die eine thermische Isolation des radial innenliegenden Bereichs 9 von einer wärmeren äußeren Umgebung 15 bewirkt. Die vakuumisolierte Hülle 13 wirkt also als Kryostat für die inneren Bereiche der Leitung. Zumindest die Kryostatinnenwand 37 weist in diesem Beispiel ein elektrisch leitendes Material auf und wirkt gleichzeitig als Leitungsschirm 29. Radial zwischen supraleitendem Leiterelement 5 und dem Leitungsschirm 29 ist eine dielektrische Isolationsschicht 31 angeordnet, die in diesem Beispiel durch das strömende Kühlmittel 11 sowie die an bestimmten Stellen angeordneten stegförmigen elektrisch isolierenden Stützelemente 39 gebildet wird. Diese dielektrische Isolationsschicht 31 weist insgesamt eine ausreichend hohe Durchschlagfestigkeit für eine Nennspannung der Übertragungsleitung 3 in der Vorrichtung zum Gleichstromübertragung auf.

Figur 2 zeigt eine Übertragungsleitung 3 einer Vorrichtung zur Stromübertragung nach einem zweiten Ausführungsbeispiel der Erfindung in einem schematischen Längsschnitt. Die Leitung 3 kann beispielsweise im Querschnitt ähnlich wie die in Figur 1 gezeigte Leitung aufgebaut sein. Im Längsschnitt der Figur 2 ist ersichtlich, dass die vakuumisolierte Hülle 13 auf einem mehrheitlichen Teil einer Längsausdehnung der Leitung 3 eine ungewellte Kryostatinnenwand 37 aufweist. In den beiden Abschnitten 43 ist die vakuumisolierte Hülle 13 als glattes, ungewelltes Rohr ausgebildet. Vorteilhaft kann dies sogar auf der ganzen Länge der Übertragungsleitung der Fall sein. Optional kann die Leitung aber auch eines oder mehrere gewellte Segmente 41 aufweisen, wie in Figur 2 dargestellt. In diesen gewellten Segmenten weist die vakuumisolierte Hülle ein wellenförmiges Profil auf, was eine mechanische Flexibilität der Leitung sowohl bezüglich Dehnung oder Stauchung als bezüglich einer Biegung in diesem Bereich erhöht. Um trotzdem einen möglichst niedrigen Strömungswiderstand und möglichst geringe Verwirbelungen des im Kühlmittelkanal 25 strömenden Kühlmittels 11 zu erreichen, ist die Kryostatinnenwand 37 in diesen Segmenten innen mit einem glattwandigen Rohreinsatz 45 ausgekleidet.

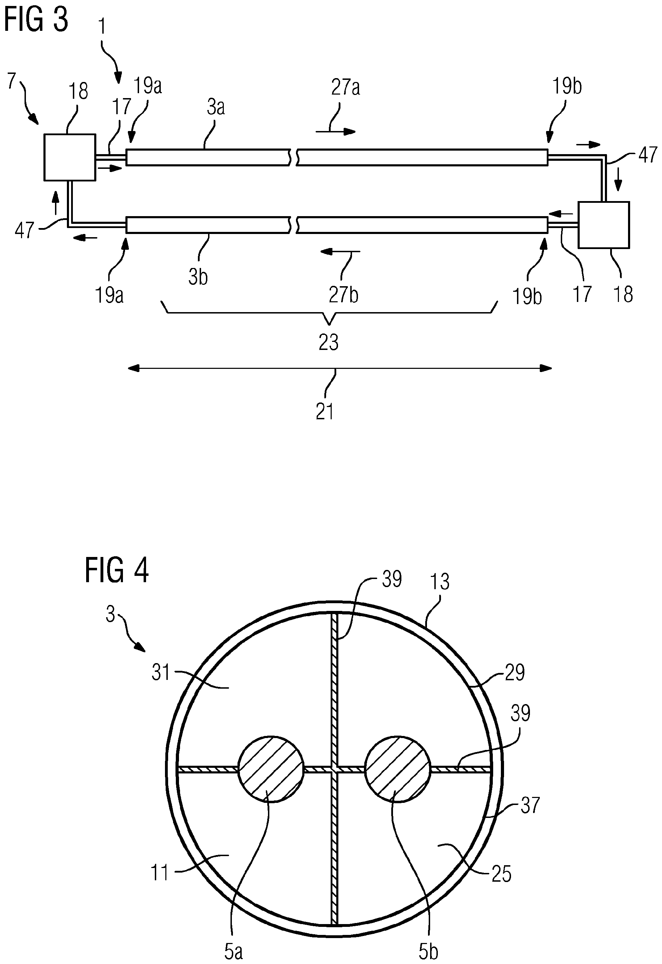

Figur 3 zeigt eine schematische Prinzipskizze einer Vorrichtung zur Gleichstromübertragung nach einem dritten Ausführungsbeispiel der Erfindung. Diese Vorrichtung 1 weist zwei Übertragungsleitungen 3a und 3b auf, die beispielsweise ähnlich wie in den Figuren 1 und 2 gezeigt aufgebaut sein können. Insbesondere können diese beiden Leitungen jeweils als einpolige Leitung mit jeweils nur einem elektrischen Leiterstrang ausgebildet sein. Durch die Nutzung beider Leitungen zur Stromübertragung wird eine zweipolige Gleichstromübertragung ermöglicht. Die Vorrichtung zur Stromübertragung weist eine Kühlvorrichtung 7 auf mit in diesem Beispiel zwei getrennten Kühleinheiten 18, in denen das fluide Kühlmittel 11 nach einer Erwärmung in den Kühlkanälen der Leitungen wieder herunter gekühlt wird. Jede der Übertragungsleitungen weist eine Gesamtlänge 21 von wenigstens 20 km auf. Jede der beiden Leitungen 3a und 3b weist an einem seiner beiden Enden eine Vorrichtung 17 zur Einspeisung von durch eine der Kühleinheiten 18 herunter gekühltes Kühlmittel in den radial innenliegenden Bereich der jeweiligen Leitung auf. Im gezeigten Beispiel weist jede der beiden Leitungen 3a und 3b nur eine solche Einspeisevorrichtung 17 auf, für die Leitung 3a ist sie am ersten Endbereich 19a angeordnet, und für die Leitung 3b ist sie am gegenüberliegenden zweiten Endbereiche 19b angeordnet. Im axial innenliegenden Bereich 23 und an den jeweils gegenüberliegenden Leitungsenden weisen die beiden Leitungen keine solchen Einspeisevorrichtungen auf. Das fluide Kühlmittel 11 zirkuliert in diesem Beispiel in einem geschlossenen Kreislauf über die Kühlmittelkanäle der beiden Leitungen 3a und 3b, die beiden Kühleinheiten 18 sowie die dazwischen angeordneten Kühlmittelrohre 47 und Einspeisevorrichtungen 17. Die Flussrichtungen 27a und 27b des Kühlmittels in den beiden Leitungen sind dazu entgegengesetzt. Durch die thermische Isolation der radial innenliegenden Bereiche 9 der Leitungen 3a und 3b wird erreicht, dass ihre jeweiligen supraleitenden Leiterelemente über die ganze Längsausdehnung 21 der Leitungen auf einer Betriebstemperatur unterhalb der Sprungtemperatur des Supraleiters gehalten werden.

Figur 4 zeigt eine Übertragungsleitung 3 für eine Vorrichtung zur Stromübertragung nach einem vierten Ausführungsbeispiel der Erfindung im schematischen Querschnitt. Gezeigt ist eine zweipolige Leitung 3 mit zwei getrennten und gegeneinander elektrisch isolierten supraleitenden Leiterelementen 5a und 5b. Im Übrigen ist die Leitung 3 ähnlich aufgebaut wie die in den Figuren 1 und 2 gezeigten einpoligen Leitungen. Die beiden Leiterelemente 5a und 5b werden auch hier durch stegartige Stützelemente 39 gegeneinander und gegen die vakuumisolierende Hülle 13 abgestützt. Wie in Figur 4 gezeigt, können diese Stützstrukturen 39 beide Leiterelemente 5a und 5b gemeinsam abstützen. Alternativ können aber auch getrennte Stützstrukturen für die beiden Leiterelemente vorgesehen sein. Allgemein ist es vorteilhaft, die beiden Leiterelemente möglichst symmetrisch bezüglich einer zentralen Achse der Leitung anzuordnen. Auch beim vierten Ausführungsbeispiel sind die Leiterelemente 5a und 5b jeweils von einer dielektrischen Isolationsschicht 31 umgeben, welche die Leiterelemente elektrisch gegeneinander und gegen den außenliegenden Leitungsschirm 29 isoliert. Diese Isolationsschicht 31 ist wiederum mehrheitlich durch das im Kühlmittelkanal 25 fließende Kühlmittel 11 in Zusammenwirkung mit den elektrisch isolierenden Stützelementen 39 gebildet. Eine solche zweipolige Übertragungsleitung 3 kann zur Übertragung von Gleichstrom in einer Vorrichtung mit nur einer einzigen solchen Leitung genutzt werden.

Alternativ zu einer solchen zweipoligen Leitung kann aber auch grundsätzlich schon eine einfache, einpolige Leitung wie in den Figuren 1 und 2 zur Übertragung von Gleichstrom genutzt werden. Da supraleitende Übertragungsleitungen vor allem im Mittel- und Hochspannungsbereich bei sehr hohen Nennströmen betrieben werden können, kann anstelle einer zweipoligen Leitung auch eine einpolige Leitung mit doppeltem Nennstrom verwendet werden, und der Rückleiter mit entgegengesetzter Stromflussrichtung kann beispielsweise durch Erde, Wasser und/oder eine Niederspannungsleitung gebildet werden.

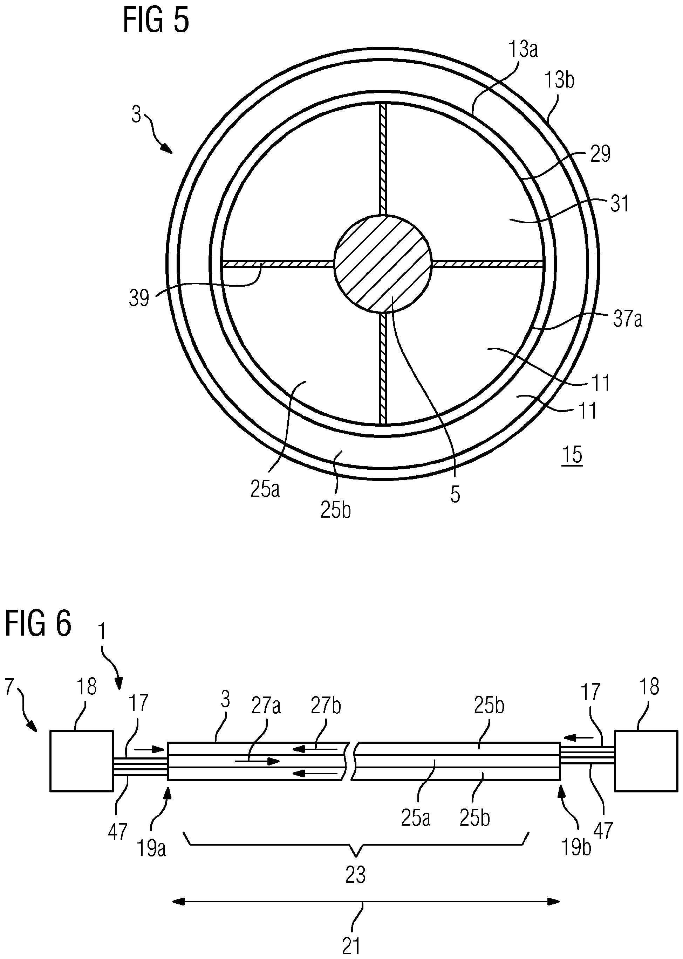

Figur 5 zeigt einen schematischen Querschnitt einer Übertragungsleitung 3 für eine Vorrichtung zur Stromübertragung nach einem fünften Ausführungsbeispiel der Erfindung. Gezeigt ist eine einpolige Leitung mit nur einem supraleitenden Leiterelement 5, ähnlich wie in der Figur 1. Im Unterschied hierzu weist die in Figur 5 gezeigte Übertragungsleitung jedoch zwei Kühlmittelkanäle auf, von denen der erste Kühlmittelkanal 25a ähnlich wie beim ersten Ausführungsbeispiel zwischen Leiterelement 5 und Leitungsschirm 29 angeordnet ist. Der Leitungsschirm 29 ist wiederum als Kryostatinnenwand 37a einer inneren vakuumisolierten Hülle 13a ausgebildet. Diese ist bei der Leitung nach dem fünften Ausführungsbeispiel von einem zweiten ringförmigen Kühlmittelkanal 25b umgeben, welcher seinerseits von einer ringförmigen äußeren vakuumisolierten Hülle 13b umgeben ist. Durch diese Anordnung zweier konzentrischer Kühlmittelkanäle 25a und 25b wird erreicht, dass das innenliegende Leiterelement 5 thermisch besonders gut gegen die warme äußere Umgebung 15 isoliert ist. Grundsätzlich kann dabei die Strömungsrichtung in den beiden Kühlmittelkanälen 25a und 25b sowohl gleich als auch entgegengesetzt sein. Eine entgegengesetzte Strömungsrichtung hat den Vorteil, dass hiermit auf einfache Weise ein geschlossener Kreislauf des Kühlmittels über eine einzelne Leitung ermöglicht werden kann.

Figur 6 zeigt eine schematische Prinzipskizze einer Vorrichtung 1 zur Stromübertragung nach einem sechsten Ausführungsbeispiel der Erfindung. Diese Vorrichtung weist eine einzelne Übertragungsleitung 3 auf, welche beispielsweise ähnlich wie in Figur 5 als einpolige Leitung mit zwei konzentrischen Kühlmittelkanälen 25a und 25b aufgebaut sein kann. Alternativ kann die Leitung aber auch als zweipolige Leitung mit zwei konzentrischen Kühlmittelkanälen 25a und 25b aufgebaut sein. Es kann sich also um eine Übertragungsleitung handeln, welches zwei innenliegende Leiterelemente 5a und 5b aufweist, ähnlich wie in Figur 4, die aber analog zur Figur 5 von zwei konzentrischen vakuumisolierten Hüllen 13a und 13b und zwei konzentrischen Kühlmittelkanälen 25a und 25b umgeben sind. Wesentlich ist, dass die Übertragungsleitung einen ersten Kühlmittelkanal 25a zum Transport des Kühlmittels entlang einer ersten Flussrichtung 27a und einen zweiten Kühlmittelkanal 25b zum Transport des Kühlmittels entlang einer entgegengesetzten zweiten Flussrichtung aufweist. Die Vorrichtung zur Stromübertragung 1 weist wiederum eine Kühlvorrichtung 7 auf, die auch in diesem Beispiel zwei Kühleinheiten 18 zur Abkühlung des im Leitungsinneren erwärmten fluiden Kühlmittels 11 umfasst. Diese beiden Kühleinheiten sind im Bereich der beiden gegenüberliegenden Leitungsenden 19a und 19b angeordnet. Jedes dieser Leitungsenden weist eine Einspeisevorrichtung 17 zum Einspeisen von Kühlmittel in einen inneren Bereich der Leitung auf. Dabei ist eine Einspeisevorrichtung 17 am ersten Endbereich 19a fluidisch mit dem inneren Kühlmittelkanal 25a und die andere Einspeisevorrichtung 17 am zweiten Endbereich 19b fluidisch mit dem äußeren Kühlmittelkanal 25b verbunden. Durch dieses Gegenstromprinzip kann einerseits ein geschlossener Kreislauf über die Länge 21 der Leitung gebildet werden, andererseits wird durch die erneute Kühlung mittels der Kühleinheiten 18 an beiden Enden eine relativ gleichmäßige Temperaturverteilung über die Länge 21 der Leitung hinweg erreicht. Dies wird insbesondere ohne zusätzliche Kühleinheiten und Einspeisevorrichtungen im axial innenliegenden Bereich 23 der Leitung erreicht.

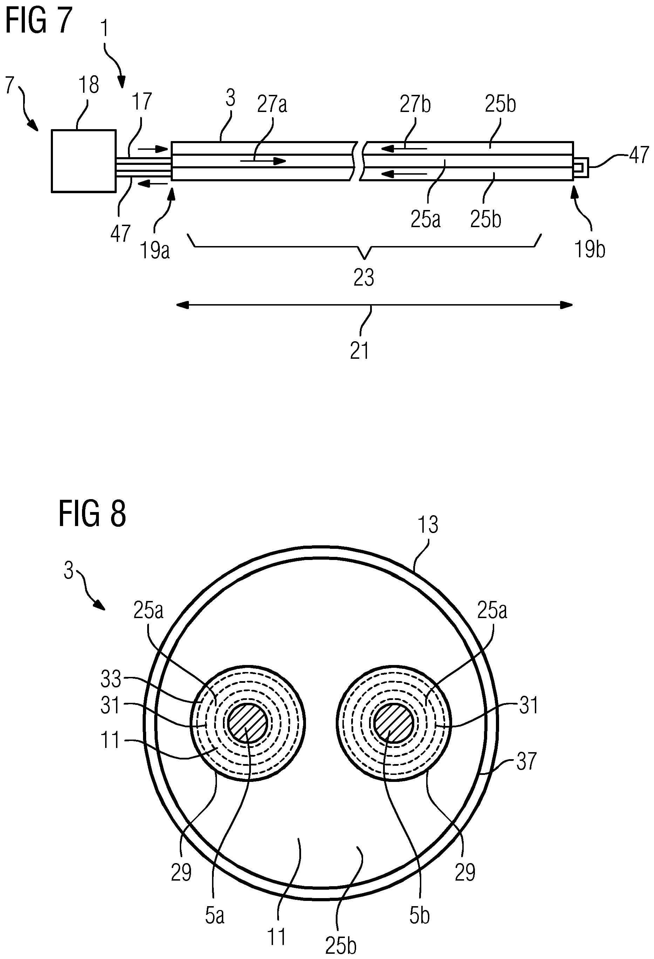

Figur 7 zeigt eine Prinzipskizze einer alternativen Vorrichtung 1 zur Gleichstromübertragung nach einem siebten Ausführungsbeispiel der Erfindung. Gezeigt ist eine Vorrichtung mit nur einer einzigen Leitung 3, welches wiederum entweder als einpolige oder als zweipolige Leitung ausgestaltet sein kann. Ähnlich wie in Figur 6 weist auch diese Leitung zwei konzentrische Kühlmittelkanäle 25a und 25b auf. Im Unterschied zum Beispiel der Figur 6 ist jedoch hier nur am ersten Endbereich 19a der Leitung eine Einspeisevorrichtung 17 zur Einspeisung von Kühlmittel 11 in das Innere der Leitung angeordnet. Im gezeigten Beispiel wird das Kühlmittel hier zuerst in den innenliegenden Kühlmittelkanal 25a eingespeist, damit das kühlere Kühlmittel näher am innenliegenden Leiterelement 5 entlang strömt. Prinzipiell kann die Reihenfolge des Durchlaufs der beiden Kühlmittelkanäle 25a und 25b jedoch auch umgekehrt sein. Am gegenüberliegenden zweiten Endbereich 19b ist der innere Kühlmittelkanal 25a mit dem äußeren Kühlmittelkanal 25b fluidisch verbunden, so dass sich auch hier ein geschlossener Kühlmittelkreislauf ergibt, allerdings in diesem Beispiel ohne eine zweite Einspeisevorrichtung. Die fluidische Verbindung kann wie in Figur 7 gezeigt über ein externes Kühlmittelrohr 47 geschaffen werden, sie kann alternativ auch im Inneren der Leitung durch eine Öffnung zwischen den beiden Kühlmittelkanälen geschaffen werden. Wesentlich ist nur, dass die beiden Kühlmittelkanäle in einem der Einspeisevorrichtung 17 gegenüberliegenden Endbereich miteinander verbunden sind.

Figur 8 zeigt einen schematischen Querschnitt einer Leitung 3 nach einem achten Ausführungsbeispiel der Erfindung. Gezeigt ist eine zweipolige Leitung mit zwei supraleitenden Leiterelementen 5a und 5b, ähnlich wie beim Beispiel der Figur 4. Im Unterschied zum vierten Ausführungsbeispiel ist hier jedoch jedes der beiden Leiterelemente 5a und 5b mit einem eigenen Leitungsschirm 29 versehen und zusammen mit diesem innerhalb eines gemeinsamen Kühlmittelkanals 25b angeordnet. Dieser gemeinsame Kühlmittelkanal 25b ist wiederum von einer gemeinsamen äußeren vakuumisolierten Hülle 13 umgeben, die in diesem Beispiel jedoch nicht als primärer Leitungsschirm, mit anderen Worten nicht als innerster Leitungsschirm wirkt. Zwischen den einzelnen Leiterelementen 5 und dem jeweiligen Leitungsschirm 29 ist jeweils eine eigene dielektrische Isolationsschicht 31 mit ringförmigem Querschnitt angeordnet. Diese Isolationsschichten 31 umgeben das zugehörige Leiterelement 5a beziehungsweise 5b jeweils konzentrisch. Jede der beiden Isolationsschichten 31 umfasst in diesem Ausführungsbeispiel eine mehrlagige Anordnung 33 eines Laminats aus PPLP, welche jeweils in einen inneren Kühlmittelkanal 25a eingebettet ist. In diesen beiden inneren Kühlmittelkanälen strömt ebenfalls fluides Kühlmittel 11 und umströmt dabei die Papierlagen 33. In diesem Beispiel ist also die dielektrische Isolationsschicht 31 der jeweiligen Leiterstränge nicht nahezu vollständig, sondern nur anteilig aus dem strömenden Kühlmittel gebildet. Der übrige Anteil ist durch die Papierlagen 33 gegeben, welche gleichzeitig eine Stützstruktur für das jeweils innenliegend angeordnete Leiterelement 5a oder 5b darstellen. Auch bei der Übertragungsleitung nach Figur 8 kann die Fließrichtung des Kühlmittels in den inneren Kühlmittelkanälen 25a einerseits und in dem gemeinsamen äußeren Kühlmittelkanal andererseits vorteilhaft entgegengesetzt sein. Beispielsweise kann eine solche Leitung dann in einer Vorrichtung ähnlich wie in den Figuren 6 oder 7 eingesetzt werden.

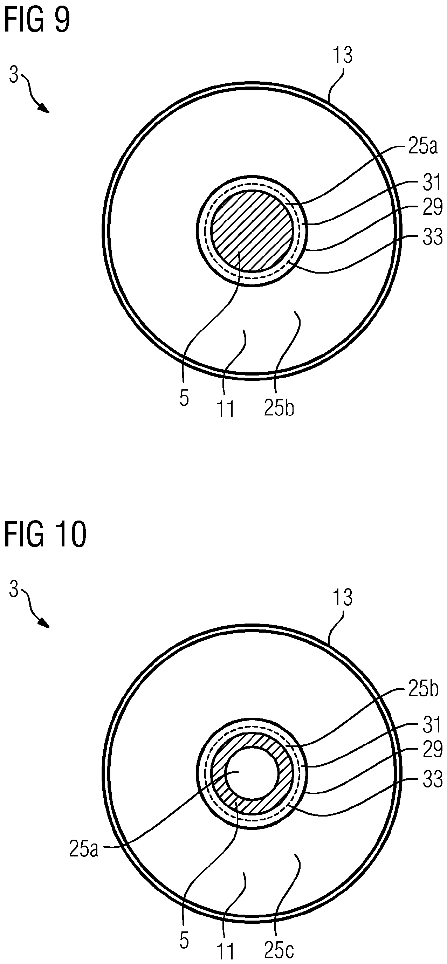

Figur 9 zeigt einen schematischen Querschnitt einer einpoligen Übertragungsleitung 3 nach einem neunten Ausführungsbeispiel der Erfindung. Der Aufbau dieser Leitung 3 ist sehr ähnlich wie bei der in Figur 8 gezeigten Leitung, sie weist allerdings nur ein supraleitendes Leiterelement 5 auf, welches radial in der Mitte der Leitung angeordnet ist. Auch hier ist das Leiterelement 5 von einer dielektrischen Isolationsschicht 31 umgeben, welche durch Zusammenwirken einer Anordnung von Papierlagen 33 und eines in einem inneren Kühlmittelkanal 25a um diese Papierlagen 33 strömenden fluiden Kühlmittels 11 gebildet wird. Radial außerhalb der dielektrischen Isolationsschicht 31 ist ein diese umgebender Leitungsschirm 29 angeordnet, der wiederum von einem äußeren Kühlmittelkanal 25b und noch weiter außen von einer vakuumisolierten Hülle 13 umgeben wird.

Figur 10 zeigt einen schematischen Querschnitt einer einpoligen Leitung 3 nach einem zehnten Ausführungsbeispiel der Erfindung. Die relative Anordnung von Leiterelement 5, dielektrischer Isolationsschicht 31 und Leitungsschirm 29 ist ähnlich wie beim neunten Ausführungsbeispiel. Auch der Aufbau der dielektrischen Isolationsschicht 31 ist ähnlich wie beim vorherigen Beispiel durch eine Kombination von Papierlagen und strömendem Kühlmittel realisiert. Im Unterschied zum vorherigen Ausführungsbeispiel ist hier jedoch ein zusätzlicher Kühlmittelkanal im Inneren des Leiterelements 5 angeordnet. Es ergeben sich hier insgesamt also drei Kühlmittelkanäle, von denen der erste 25a im Zentrum der Leitung angeordnet ist, der zweite 25b mit Papierlagen 33 ausgekleidet ist und das Leiterelement 5 radial umgibt und der dritte 25c radial zwischen Leitungsschirm 29 und vakuumisolierter Hülle 13 angeordnet ist. Die Flussrichtungen in den ineinander geschachtelten Kühlmittelkanälen können wiederum vorteilhaft alternierend wechseln. Ein ähnlicher Aufbau wie in Figur 10 ist grundsätzlich auch für eine zweipolige Leitung denkbar, bei dem jedes Leiterelement innen von einem zusätzlichen Kühlmittelkanal durchsetzt ist.

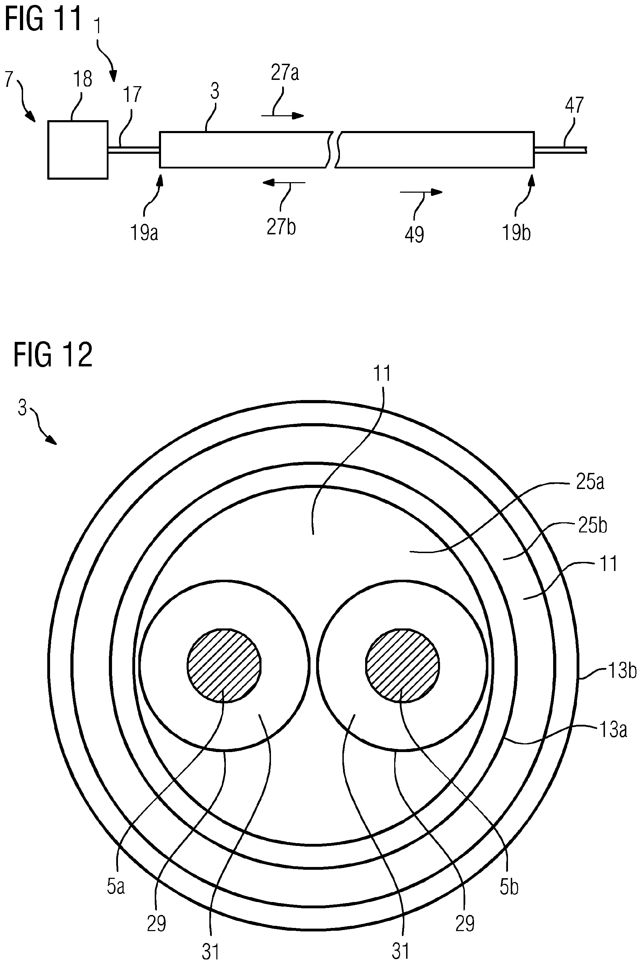

Figur 11 zeigt eine Prinzipskizze einer Vorrichtung zur Gleichstromübertragung nach einem elften Ausführungsbeispiel der Erfindung. Gezeigt ist wiederum eine Vorrichtung mit nur einer einzelnen Übertragungsleitung 3, welche beispielsweise gemäß einer der verschiedenen gezeigten Leitungsquerschnitte aufgebaut sein kann. So kann diese Leitung allgemein ein- oder zweipolig ausgestaltet sein, und es kann einen oder mehrere Kühlmittelkanäle aufweisen. Die Kühlvorrichtung 7 zur Kühlung des wenigstens einen Leiterelements weist zumindest eine Einspeisevorrichtung 18 an einem Endbereich 19a der Leitung auf, es können aber auch Einspeisevorrichtung an beiden Endbereichen vorliegen. Wesentlich für dieses elfte Ausführungsbeispiel ist, dass ein Netto-Stofftransport des Kühlmittels entlang einer Längsrichtung der Leitung stattfindet. Es handelt sich im gezeigten Beispiel um einen Stofftransport entlang einer ersten Flussrichtung 27a vom ersten Endbereich 19a hin zum zweiten Endbereich 19b der Leitung. Zusätzlich kann auch ein gleichzeitiger Stofftransport in entgegengesetzter Flussrichtung 27b vorliegen, der jedoch beim gezeigten Beispiel geringer ist als der Stofftransport in der ersten Flussrichtung 27a. Mit andern Worten kann die Vorrichtung zur Gleichstromübertragung gleichzeitig zur Übertragung von Kühlmittel entlang der Leitung 3 genutzt werden. Insbesondere kann die für den Stofftransport maßgebliche erste Flussrichtung 27a gleich sein mit der Übertragungsrichtung 49 der elektrischen Energie. Dies ist besonders vorteilhaft, um von einem Ort, an dem viel Energie zur Verfügung steht, sowohl elektrische Energie als auch durch Elektrolyse erzeugten Wasserstoff an einen anderen Ort zu transportieren.

Figur 12 zeigt einen schematischen Querschnitt einer weiteren Übertragungsleitung 3 nach einem zwölften Ausführungsbeispiel der Erfindung. Gezeigt ist eine zweipolige Leitung mit zwei Leiterelementen 5a und 5b welches ähnlich wie das in Figur 5 zwei konzentrische vakuumisolierte Hüllen 13a und 13b aufweist, wobei innerhalb der inneren Hülle 13a ein innerer Kühlmittelkanal 25a und zwischen den beiden Hüllen ein äußerer Kühlmittelkanal 25b angeordnet ist. Im Unterschied zu den vorab gezeigten Ausführungsbeispielen der Leitungsquerschnitte sind die beiden Leiterelemente jeweils durch Festkörperdielektrika als Isolationsschicht 31 von ihren jeweiligen innersten Leitungsschirmen 29 elektrisch isoliert. Der innere Kühlmittelkanal 25a umgibt diese beiden derart isolierten und geschirmten Leitungsstränge gemeinsam. Auch mit einem solchen Aufbau kann durch die ineinander geschachtelte Anordnung von Kühlkanälen und vakuumisolierten Hüllen eine hohe thermische und elektrische Abschirmung der Leiterelemente erzielt werden.

## Patentansprüche

1. Vorrichtung (1) zur Gleichstromübertragung mit
- einer supraleitenden Übertragungsleitung (3) mit wenigstens einem supraleitenden Leiterelement (5) und
- einer Kühlvorrichtung (7) zur Kühlung eines radial innenliegenden Bereichs (9) der Übertragungsleitung (3) mit Hilfe eines fluiden Kühlmittels (11) auf eine Temperatur unterhalb einer Sprungtemperatur des supraleitenden Leiterelements (5),
- wobei die supraleitende Übertragungsleitung (3) eine vakuumisolierte Hülle (13) zur thermischen Trennung des innenliegenden Bereichs (9) der Übertragungsleitung (3) von einer wärmeren äußeren Umgebung (15) aufweist,
- wobei die Kühlvorrichtung (7) wenigstens eine Einspeisevorrichtung (17) zur Einspeisung von Kühlmittel (11) an einem Endbereich (19a) der Übertragungsleitung (3) in den radial innenliegenden Bereich (9) der Übertragungsleitung (3) umfasst,
- wobei die Übertragungsleitung (3) bei einer axialen Längsausdehnung (21) von wenigstens 20 km frei von axial innenliegend angeordneten Einspeisevorrichtungen zur Einspeisung von Kühlmittel ist
- wobei die Übertragungsleitung (3) einen das supraleitende Leiterelement (5) ringförmig umgebenden elektrisch leitenden Leitungsschirm (29) und
- zwischen supraleitendem Leiterelement (5) und Leitungsschirm (29) eine ringförmige dielektrische Isolationsschicht (31) und
- wenigstens einen das supraleitende Leiterelement (5) ringförmig umgebenden Kühlmittelkanal (25a,25b) zum Transport von fluidem Kühlmittel (11) entlang einer Längsrichtung der Übertragungsleitung (3) aufweist,
**dadurch gekennzeichnet, dass**
- die dielektrische Isolationsschicht (31) im Wesentlichen durch den mit Kühlmittel gefüllten ringförmigen Kühlmittelkanal gebildet ist, und
- radial durchgehende axiale Segmente und/oder azimutale Segmente der Übertragungsleitung vorliegen, in denen die dielektrische Isolationsschicht vollständig durch fluides Kühlmittel gebildet ist.

2. Vorrichtung (1) nach Anspruch 1, bei der die dielektrische Isolationsschicht (31) eine Durchschlagfestigkeit von wenigstens 20 kV/mm aufweist.

3. Vorrichtung (1) nach einem der vorhergehenden Ansprüche, bei der die dielektrische Isolationsschicht (31) wenigstens eine Schicht eines in Kühlmittel (11) eingebetteten Papiers (33) aufweist.

4. Vorrichtung (1) nach einem der vorhergehenden Ansprüche, bei der das fluide Kühlmittel (11) im Inneren der Übertragungsleitung (3) zumindest auf einem mehrheitlichen Teil der Längsausdehnung der Übertragungsleitung im Inneren eines glattwandigen Rohrs (35) geführt ist.

5. Vorrichtung (1) nach einem der vorhergehenden Ansprüche, bei der das supraleitende Leiterelement (5) ein hochtemperatursupraleitendes Material umfasst.

6. Vorrichtung (1) nach Anspruch 5, bei der das hochtemperatursupraleitende Material Magnesiumdiborid umfasst.

7. Vorrichtung (1) nach einem der vorhergehenden Ansprüche, bei der die Kühlvorrichtung (7) nur an einem der Endbereiche (19a) der Übertragungsleitung (3) eine Einspeisevorrichtung (17) zur Einspeisung von Kühlmittel (11) aufweist.

8. Vorrichtung (1) nach einem der vorhergehenden Ansprüche, bei der die Übertragungsleitung zwei fluidisch getrennte Kühlmittelkanäle (25a,25b) zum Transport des fluiden Kühlmittels (11) in entgegengesetzten Richtungen (27a,27b) aufweist.

9. Vorrichtung (1) nach einem der vorhergehenden Ansprüche, bei der die Übertragungsleitung (3) als zweipoliges Leitung mit zwei elektrisch voneinander isolierten supraleitenden Leiterelementen (5a,5b) innerhalb einer gemeinsamen vakuumisolierten Hülle (13) ausgestaltet ist.

10. Vorrichtung (1) nach einem der vorhergehenden Ansprüche, bei der die Übertragungsleitung (3) zwei koaxial zueinander verlaufende Kühlmittelkanäle (25a,25b) aufweist.

11. Vorrichtung (1) nach einem der vorhergehenden Ansprüche, bei der das fluide Kühlmittel (11) Stickstoff, Wasserstoff, Helium und/oder Neon umfasst.

## Claims

1. Device (1) for DC transmission comprising
- a superconducting transmission line (3) having at least one superconducting conductor element (5), and
- a cooling device (7) for cooling a radially inner region (9) of the transmission line (3) with the aid of a fluid coolant (11) to a temperature below a critical temperature of the superconducting conductor element (5),
- wherein the superconducting transmission line (3) has a vacuum-insulated sleeve (13) for thermally isolating the inner region (9) of the transmission line (3) from a warmer outer surrounding area (15),
- wherein the cooling device (7) comprises at least one feed device (17) for feeding coolant (11) at an end region (19a) of the transmission line (3) into the radially inner region (9) of the transmission line (3),
- wherein the transmission line (3), given an axial longitudinal extent (21) of at least 20 km, is free of axially internally arranged feed devices for feeding coolant,
- wherein the transmission line (3) has an electrically conductive line shield (29) which surrounds the superconducting conductor element (5) in an annular manner and
- an annular dielectric insulation layer (31) between the superconducting conductor element (5) and the line shield (29) and
- at least one coolant channel (25a, 25b), which surrounds the superconducting conductor element (5) in an annular manner, for transporting fluid coolant (11) along a longitudinal direction of the transmission line (3),
- **characterized in that** the dielectric insulation layer (31) is formed substantially by the annular coolant channel which is filled with coolant, and
- there are radially continuous axial segments and/or azimuthal segments of the transmission line, in which segments the dielectric insulation layer is formed entirely by fluid coolant.

2. Device (1) according to Claim 1, in which the dielectric insulation layer (31) has a breakdown strength of at least 20 kV/mm.

3. Device (1) according to one of the preceding claims, in which the dielectric insulation layer (31) has at least one layer of a paper (33) which is embedded in coolant (11).

4. Device (1) according to one of the preceding claims, in which the fluid coolant (11) is guided in the interior of a smooth-walled tube (35) at least over a major portion of the longitudinal extent of the transmission line in the interior of the transmission line (3).

5. Device (1) according to one of the preceding claims, in which the superconducting conductor element (5) comprises a high-temperature superconducting material.

6. Device (1) according to Claim 5, in which the high-temperature superconducting material comprises magnesium diboride.

7. Device (1) according to one of the preceding claims, in which the cooling device (7) has a feed device (17) for feeding coolant (11) only at one of the end regions (19a) of the transmission line (3).

8. Device (1) according to one of the preceding claims, in which the transmission line has two fluidically isolated coolant channels (25a, 25b) for transporting the fluid coolant (11) in opposite directions (27a, 27b).

9. Device (1) according to one of the preceding claims, in which the transmission line (3) is designed as a two-pole line with two superconducting conductor elements (5a, 5b), which are electrically insulated from one another, within a common vacuum-insulated sleeve (13).

10. Device (1) according to one of the preceding claims, in which the transmission line (3) has two coolant channels (25a, 25b) which run coaxially in relation to one another.

11. Device (1) according to one of the preceding claims, in which the fluid coolant (11) comprises nitrogen, hydrogen, helium and/or neon.

## Revendications

1. Dispositif (1) de transport de courant continu, comprenant
- une ligne (3) supraconductrice de transport ayant au moins un élément (5) conducteur supraconducteur et
- un dispositif (7) de refroidissement pour refroidir une partie (9) intérieure radialement de la ligne (3) de transport à l'aide d'un fluide (11) de refroidissement à une température inférieure au point de changement brusque de la conductivité de l'élément (5) conducteur supraconducteur,
- dans lequel la ligne (3) supraconductrice de transport a une gaine (13) à isolation par le vide, pour séparer thermiquement la partie (9) intérieure de la ligne (3) de transport d'un environnement (15) extérieur plus chaud,
- dans lequel le dispositif (7) de refroidissement comprend au moins un dispositif (17) d'injection, pour injecter du fluide (11) de refroidissement à une partie (19a) d'extrémité de la ligne (3) de transport dans la partie (9) intérieure radialement de la ligne (3) de transport,
- dans lequel la ligne (3) de transport est, pour une étendue (21) longitudinale axiale d'au moins 20 km, sans dispositif, disposé à l'intérieur axialement, d'injection de fluide de refroidissement
- dans lequel la ligne (3) de transport a un blindage (29) conducteur de l'électricité, qui entoure annulairement l'élément (5) conducteur supraconducteur et
- une couche (31) annulaire diélectrique isolante entre l'élément (5) conducteur supraconducteur et le blindage (29) et
- au moins un canal (25a, 25b) pour du fluide de refroidissement entourant annulairement l'élément (5) conducteur supraconducteur, afin de transporter du fluide (11) de refroidissement suivant une direction longitudinale de la ligne (3) de transport **caractérisé en ce que**
- la couche (31) diélectrique isolante est formée essentiellement par le canal annulaire pour du fluide de refroidissement empli du fluide du fluide de refroidissement et
- il y a des segments axiaux continus radialement et/ou des segments azimutaux de la ligne de transport, dans lesquels la couche diélectrique isolante est formée complètement par du fluide de refroidissement.

2. Dispositif (1) suivant la revendication 1, dans lequel la couche (31) diélectrique isolante a une rigidité diélectrique de moins de 20 kV/mm.

3. Dispositif (1) suivant l'une des revendications précédentes, dans lequel la couche (3) diélectrique isolante a au moins une couche d'un papier (33) noyé dans du fluide (11) de refroidissement.

4. Dispositif (1) suivant l'une des revendications précédentes, dans lequel le fluide (11) de refroidissement passe à l'intérieur de la ligne (3) de transport, au moins sur une partie prépondérante de l'étendue longitudinale de la ligne de transport, à l'intérieur d'un tube (35) à paroi lisse.

5. Dispositif (1) suivant l'une des revendications précédentes, dans lequel l'élément (5) conducteur supraconducteur comprend un matériau supraconducteur à haute température.

6. Dispositif (1) suivant la revendication 5, dans lequel le matériau supraconducteur à haute température comprend du diborure de magnésium.

7. Dispositif (1) suivant l'une des revendications précédentes, dans lequel le dispositif (7) de refroidissement a un dispositif (17) d'injection de fluide (11) de refroidissement, seulement à l'une des parties (19a) d'extrémité de la ligne (3) de transport.

8. Dispositif (1) suivant l'une des revendications précédentes, dans lequel la ligne de transport a deux canaux (25a, 25b) séparés fluidiquement pour du fluide de refroidissement pour le transport du fluide (11) de refroidissement dans des sens (27a, 27b) contraires.

9. Dispositif (1) suivant l'une des revendications précédentes, dans lequel la ligne (3) de transport est conformée en ligne bipolaire ayant deux éléments conducteurs supraconducteurs isolés électriquement l'un de l'autre à l'intérieur d'une gaine (13) commune à isolation par le vide.

10. Dispositif (1) suivant l'une des revendications précédentes, **caractérisé en ce que** la ligne (3) de transport a deux canaux (25a, 25b) pour du fluide de refroidissement s'étendant coaxialement l'un à l'autre.

11. Dispositif (1) suivant l'une des revendications précédentes, dans lequel le fluide (11) de refroidissement comprend de l'azote, de l'hydrogène, de l'hélium et/ou du néon.
